Europäisches Patentamt

(19) European Patent Office

Office européen des brevets

(11) Publication number: **0 060 108**
**B1**

(12) **EUROPEAN PATENT SPECIFICATION**

(45) Date of publication of patent specification: **17.08.88**

(51) Int. Cl.⁴: **G 11 C 11/24**

(21) Application number: **82301141.6**

(22) Date of filing: **05.03.82**

(54) Address buffer.

(30) Priority: **05.03.81 JP 31750/81**

(43) Date of publication of application:
**15.09.82 Bulletin 82/37**

(45) Publication of the grant of the patent:
**17.08.88 Bulletin 88/33**

(84) Designated Contracting States:
**DE FR GB NL**

(56) References cited:
**WO-A-81/03567**
**US-A-4 207 618**

**INTERNATIONAL SOLID-STATE CIRCUITS CONFERENCE, 15th February 1979, pages 142-143, New York, US; J.M.LEE et al.: "A 80ns 5V-only dynamic RAM"**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshihiro**
**1-20-5-9-301, Utsukushigaoka Midori-ku**
**Yokohama-shi Kanagawa 227 (JP)**
Inventor: **Nozaki, Shigeki**
**473-4-203, Hisasue Takatsu-ku**
**Kawasaki-shi Kanagawa 213 (JP)**
Inventor: **Kabashima, Katsuhiko**
**407-1, Miyauchi Nakahara-ku**
**Kawasaki-shi Kanagawa 211 (JP)**
Inventor: **Enomoto, Seiji**
**3-16-403, Susukino-Danchi Midori-ku**
**Yokohama-shi Kanagawa 227 (JP)**
Inventor: **Mezawa, Tsutomu**
**81, Aza Muranishi Oaza Tsuruga Ikki-machi**
**Aizuwakamatsu-shi Fukushima 965 (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

Courier Press, Leamington Spa, England.

EP 0 060 108 B1

## Description

The present invention relates to a semiconductor memory device with address buffer circuitry and, more particularly, to a dynamic memory device which contains therein an address counter for achieving a refresh operation with respect to data stored in the memory.

As is well known, a dynamic memory, such as a RAM, needs a refresh operation so as to prevent the data stored in the memory from fading away. In a typical and conventional dynamic memory, an address for achieving the refresh is sequentially supplied, each time that a refresh operation is necessary, from an external address generator located outside the memory. However, lately there has been a tendency to generate such an address inside the memory, so that it is not necessary to prepare and employ the above-mentioned external address generator. Such an internal address generator is called a refresh counter. Accordingly, the memory needs no external refresh address, but merely requires an external instruction to commence each refresh operation therein. Each time the refresh instruction is supplied to the memory, an internal refresh address is sequentially supplied to the word lines, one by one, of the memory.

During each rest term of the refresh operation, the memory cooperates with peripheral units, such as a central processing unit (CPU), periodically. In this case, the memory is accessed not by an internal refresh address, but by an external address supplied from the peripheral unit. Therefore, the memory is selectively accessed by an internal refresh address and an external address. Either the internal refresh address or the external address is then applied to an address decoder, by way of the address buffer. Generally, an address buffer has two major functions. The first is to produce simultaneously both an address (A) and an inverting address ($\overline{A}$), which address (A) is identical to a supplied internal refresh address or a supplied external address. The second is to convert the level of the supplied address, such as the TTL level, into a high level address (A, $\overline{A}$), such as the MOS level.

Currently used address buffers may be unable to operate at high speeds. The reason for this will be explained in detal hereinafter. Thus, the currently used address buffer may not have sufficient capability to cope with the very high speed data processing conducted in, for example, a super computer system.

Therefore, it it desirable to improve the operating speed of address buffers.

According to one aspect of the present invention there is provided a dynamic memory device including address buffer circuitry provided with input means connected to apply either an external address signal or an internal refresh address signal to a first input/output node of a flip-flop of the address buffer circuitry so that the flip-flop is latched into either one of its two stable states upon receipt of the external address signal or upon receipt of the internal refresh address signal; the said input means including first input circuitry, connected to the said first input/output node of the flip-flop and comprising first and second transistors connected together in series, and also including second input circuitry, connected to a second input/output node of the flip-flop and comprising third and fourth transistors connected together in series, the gate of the said third transistor being connected to receive a basic timing clock signal from an address drive clock generator of the device and the gate of the said fourth transistor being connected to receive a reference voltage; there being output circuitry coupled to the said flip-flop for producing output address signals;

characterised in that the device further includes switching means operable to switch the said basic timing clock signal so as to produce either an internal refresh address timing clock signal, during a period in which a refresh operation of the device is to be performed, or an external address timing clock signal, during a period of normal operation of the device, which clock signals are delivered to the said input means;

and in that the said input means further include third input circuitry connected in parallel with the said first input circuitry and comprising fifth and sixth transistors connected together in series, respective gates of the said fifth and sixth transistors being connected to receive respectively the said internal refresh address timing clock signal and the said internal refresh address signal;

and in that respective gates of the said first and second transistors of the first input circuitry are connected to receive respectively the said external address timing clock signal and the said external address signal.

According to another aspect of the present invention there is provided a dynamic memory device including address buffer circuitry provided with input means connected to apply either an external address signal or an internal refresh address signal to a first input/output node of a flip-flop of the address buffer circuitry so that the flip-flop is latched into either one of its two stable states upon receipt of the external address signal or upon receipt of the internal refresh address signal; the said input means including first input circuitry, connected to the said first input/output node of the flip-flop and comprising first and second transistors connected together in series, and also including second input circuitry, connected to a second input/output node of the flip-flop and comprising third and fourth transistors connected together in series, the gate of the said fourth transistor being connected to receive a reference voltage; there being output circuitry coupled to the said flip-flop for producing output address signals;

characterised in that the device further includes switching means operable to switch a basic timing clock signal from an address drive clock generator of the device so as to produce either an internal refresh address timing clock signal, during a period in which a refresh operation of the device is to be performed, or an external address timing clock signal, during a period of normal operation of the device, which clock signals are delivered to the said input means;

and in that the said input means further include third input circuitry connected in parallel with the said first input circuitry and comprising fifth and sixth transistors connected together in series, respective gates of the said fifth and sixth transistors being connected to receive respectively the said internal refresh address timing clock signal and the said internal refresh address signal, and also include fourth input circuitry connected in parallel with the said second input circuitry for receiving an inverted internal refresh address signal and the said internal refresh address timing clock signal;

and in that respective gates of the said first and third transistors of the first and second input circuitry are connected to receive the said external address timing clock signal and a gate of the said second transistor of the first input circuitry is connected to receive the said external address signal.

Attention has been drawn to WO81/03567 which is cited in accordance with 4.54 (3) and (4) and which is concerned with providing refresh operations for a dynamic memory device and discloses circuitry for applying either an externally-supplied address or an internally-generated refresh address to input circuitry, comprising series-connected transistors, provided at the input of an address buffer. This document does not disclose the circuitry arrangement required by the present invention.

Reference will now be made, by way of example, to the accompanying drawings, in which:

Fig. 1 illustrates a circuit diagram of a dynamic memory device including an address buffer;

Fig. 2 is a detailed circuit diagram representing the address buffer and a multiplexer shown in Fig. 1;

Fig. 3 is a timing diagram used for explaining an operation, especially a refresh operation, of the circuit shown in Fig. 2;

Fig. 4 illustrates a circuit diagram of a dynamic memory device embodying the present invention, which employs therein an address buffer circuit;

Fig. 5 is a detailed circuit diagram representing the address buffer circuit shown in Fig. 4;

Fig. 6A is a timing diagram used for explaining the operation of the address buffer circuit shown in Fig. 5 during a refresh operation mode; and

Fig. 6B is a timing diagram used for explaining the operation of the address buffer circuit shown in Fig. 5 during a normal operation mode.

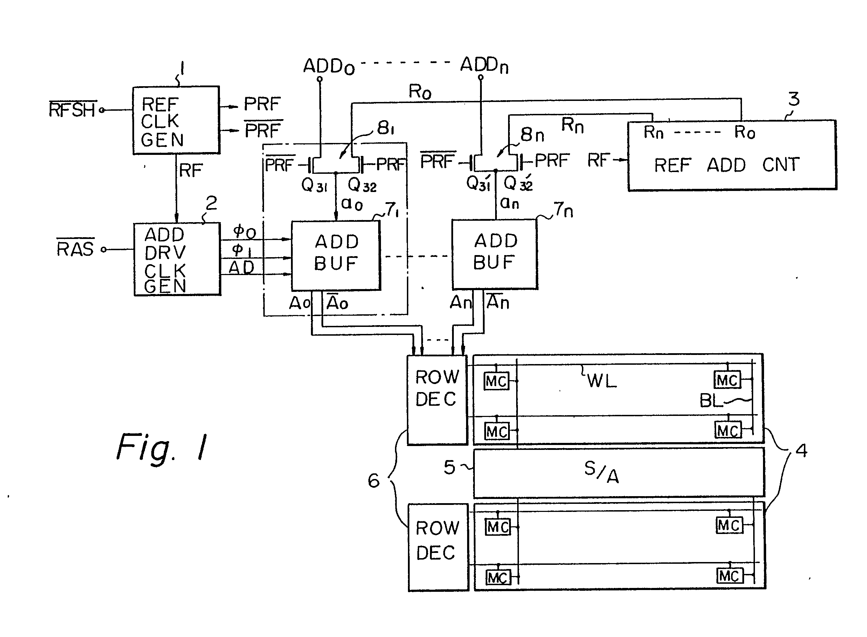

In Fig. 1, the reference numeral 1 represents a refresh clock generator (REF CLK GEN), 2 an address drive clock generator (ADD DRV CLK GEN), 3 an internal refresh address counter (REF ADD CNT), 4 memory cell arrays, 5 a sense amplifier (S/A) including column decoders (not shown) therein, 6 row decoders (ROW DEC), $7_1$ to $7_n$ address buffers (ADD BUF), and $8_1$ to $8_n$ multiplexers. The multiplexers $8_1$ to $8_n$ produce inputs $a_0$ to $a_n$ respectively for delivery to the address buffers $7_1$ to $7_n$. The inputs $a_0$ to $a_n$ are specified by either an external address $ADD_0$ to $ADD_n$, during a normal operation mode, or a refresh address $R_0$ to $R_n$, which is the output of the internal refresh address counter 3, during a refresh operation mode.

The refresh clock generator 1 receives an external clock signal $\overline{RFSH}$ and then produces clock signals PRF, $\overline{PRF}$ and RF. The clock $\overline{RFSH}$ is logic "L" when a refresh operation is to occur and when the clock $\overline{RFSH}$ is logic "H", a normal operation is to occur.

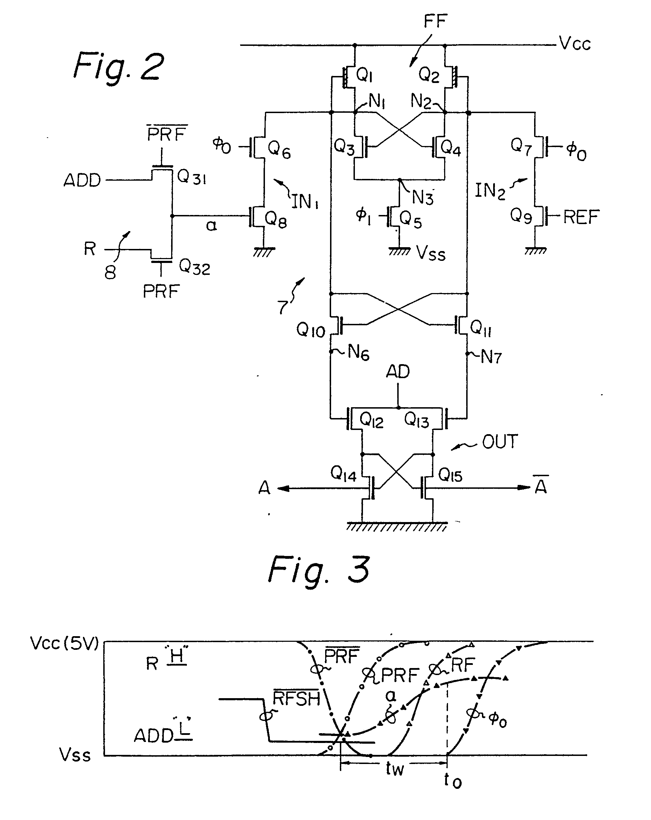

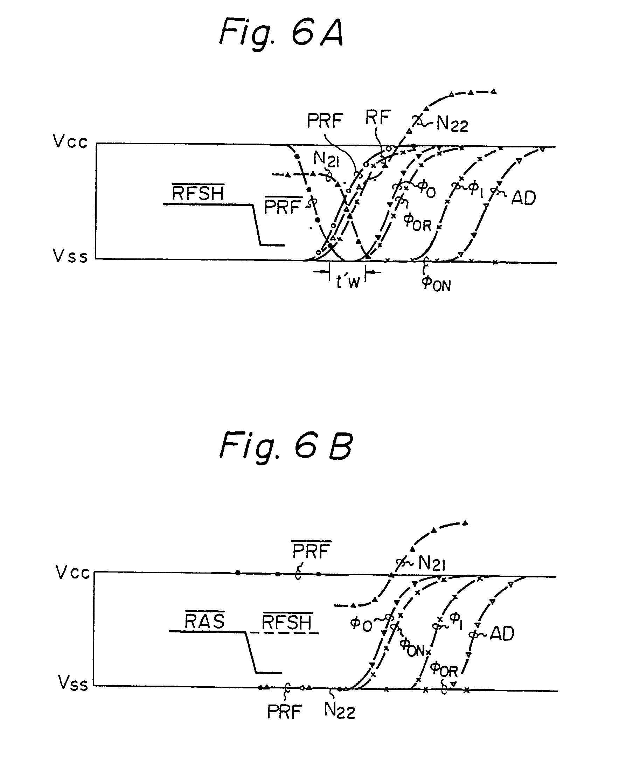

According to the logic of the clock $\overline{RFSH}$, the lock of the clock PRF or the clock $\overline{PRF}$ becomes "H". When the logic of the clock $\overline{RFSH}$ is "L", the clock PRF is changed to logic "H", and, accordingly, the refresh addresses $R_0$ to $R_n$ are selected as the inputs $a_0$ to $a_n$ respectively, via transistors $Q_{32}$ to $Q'_{32}$. Contrary to this, if the clock $\overline{RFSH}$ is logic "H", the clock $\overline{PRF}$ is made logic "H", and, accordingly, the external addresses $ADD_0$ to $ADD_n$ are selected as the inputs $a_0$ to $a_n$ respectively, via transistors $Q_{31}$ to $Q'_{31}$. The clock RF (also shown in Figs. 3 and 6A) is used for activating the address drive clock generator 2. The address drive clock generator 2 receives the clock RF and then produces clock signals $o_0$, $o_1$ and AD, sequentially. The address drive clock generator 2 is triggered by a trigger pulse $\overline{RAS}$ (row address strobe). The pulse $\overline{RAS}$ is generated in synchronism with the so-called machine cycle, and it is used in the normal operation mode.

In the memory cell arrays 4, the reference symbol WL denotes a word line, BL a bit line, and MC a memory cell. A memory cell MC is located at each cross point of the word lines WL and bit lines BL.

Fig. 2 is a detailed circuit diagram of the address buffer (ADD BUF) $7_1$ to $7_n$ and the multiplexer 8 shown in Fig. 1. Since, in Fig. 1, the address buffers $7_1$ to $7_n$ have the same construction as one another, and also since the multiplexers $8_1$ to $8_n$ have the same construction as one another, only one of the address buffers 7 and only one of the multiplexers 8 are illustrated in Fig. 2. The multiplexer 8 receives, at respective inputs thereof, the external address ADD and the refresh address R, selectively, and the addres buffer 7 produces the addresses A and $\overline{A}$, according to the output of the multiplexer 8. It should be understood that the reference symbols ADD, R, a, A, $\overline{A}$, 7 and 8 are respectively classified into each bit of address by using the suffixes 0 to n.

As previously mentioned, in the multiplexer 8 the MOS transistor $Q_{31}$ is controlled, at its gate, by the clock $\overline{PRF}$, so that if the external clock $\overline{RFSH}$ (Fig. 1) is changed to logic "H", the clock $\overline{PRF}$ is changed to logic "H", and, the external clock ADD thereby becomes effective. On the other hand, the MOS transistor $Q_{32}$ is controlled, at its gate, by the clock PRF, so that if the external clock $\overline{\text{RFSH}}$ (Fig. 1) is changed to logic "L", the clock PRF is changed to logic "H", and, thereby, the refresh address R supplied from the counter 3 (Fig. 1) becomes effective. Consequently, during normal operation mode, logical conditions stand. That is, $\overline{\text{RFSH}}$ is "H" and also $\overline{\text{PRF}}$ is "H". In this case, since the MOS transistor $Q_{31}$ is turned ON, the input $a$ for the address buffer 7 is specified by the external address ADD. However, when the refresh operation mode occurs, the logic of the external clock $\overline{\text{RFSH}}$ changes from "H" to "L", as shown in Fig. 3 which is a timing diagram used for explaining the operation (especially the refresh operation) of the circuit shown in Fig. 2. At this time, the output from the reference clock generator 1 (Fig. 1), that is the clock $\overline{\text{PRF}}$, changes from logic "H" to logic "L", while the clock PRF changes from logic "L" to logic "H". Accordingly, the MOS transistor $Q_{32}$ is turned ON and, thereby, the input $a$ is specified by the refresh address R. The timing diagram of Fig. 3 shows, as an example, a case where the refresh address R has logic "H" and the external address ADD has logic "L".

The address buffer 7 comprises MOS transistors $Q_1$ to $Q_{15}$, as shown in Fig. 2. Of these transistors, the MOS transistors $Q_1$ to $Q_5$ constitute a flip-flop FF, having two stable states, which functions as a main amplifier. The flip-flop FF includes nodes $N_1$ and $N_2$ which functions as a pair of input terminals, and as a pair of output terminals, of the flip-flop FF alternatively. The node $N_1$ is provided with an external address input circuit $IN_1$ which comprises the MOS transistors $Q_6$ and $Q_8$ connected in series. The node $N_2$ is provided with a reference voltage input circuit $IN_2$ which comprises the MOS transistor $Q_7$ and $Q_9$ connected in series. Further, the nodes $N_1$ and $N_2$ are provided with an output circuit OUT which comprises the MOS transistors $Q_{10}$ to $Q_{15}$. The output circuit OUT functions to pick up the amplified signal produced from the flip-flop (main amplifier) FF and produces the addresses A and $\overline{A}$.

The operation of the address buffer 7 is started by the application of the clock $\phi_0$ thereto. That is, when the clock $\phi_0$ starts rising, as shown by a curve labelled $\phi_0$ in Fig. 3, the MOS transistors $Q_6$ and $Q_7$ are turned ON. In this case, the MOS transistor $Q_9$ is always maintained in a conductive state due to the presence of the reference voltage REF at its gate. Accordingly, the level at the node $N_2$ is set to be a certain level which is determined by the ratio of the mutual conductances $g_m$ between the transistors $Q_2$ (depletion MOS transistor), $Q_7$ and $Q_9$. Generally, the value of the mutual conductance $g_m$ is determined by various factors, such as the size of the MOS transistor and voltage level applied to the gate thereof.

On the other hand, the MOS transistor $Q_8$, to which the input $a$ is applied at its gate, is turned ON or OFF in accordance with logic "H" or "L" of the input $a$. When the input $a$ is logic "H", the transistor $Q_8$ is turned ON, and, accordingly, a current flows through the MOS transistors $Q_1$ (depletion MOS transistor), $Q_6$ and $Q_8$. At this time, the voltage level at the node $N_1$ is determined by the ratio of the mutual conductances $g_m$ defined by the respective transistors $Q_1$, $Q_6$ and $Q_8$. In this case, the value of $g_m$ defined by the transistor $Q_8$ is designed in advance to be larger than the value of $g_m$ defined by the aforementioned transistor $Q_9$ receiving the reference voltage REF. As a result, the relationship $V_{N1} < V_{N2}$ is obtained, where the symbols $V_{N1}$ and $V_{N2}$ denote the voltage levels developed at the nodes $N_1$ and $N_2$, respectively. In contrast, if the input $a$ is changed to logic "L", the relationship $V_{n1} > V_{N2}$ is obtained, where the voltage $V_{N1}$ is almost the same as the voltage level $V_{CC}$ (Figs. 2 and 3). Thus, either the relationship $V_{N1} < V_{N2}$ or the relationship $V_{N1} > V_{N2}$ is created in accordance with the logic "H" or "L", respectively, of the input $a$.

Generally, the difference between the voltages $V_{N1}$ and $V_{N2}$ is very small, and, therefore, the above-recited two relationships are not remarkably distinguished from one another. In order to achieve a greater distinction between these two relationships, the voltage levels $V_{N1}$ and $V_{N2}$ are amplified by the aforementioned flip-flop (main amplifier) FF. The flip-flop FF is energized by the clock $\phi_1$ applied to the gate of the transistor $Q_5$. The clock $\phi_1$ follows the clock $\phi_0$, as shown in Figs. 6A and 6B (but not shown in Fig. 3). When the transistor $Q_5$ is turned ON by the clock $\phi_1$, the voltage level at a node $N_3$ of the flip-flop FF is changed to a ground level $V_{SS}$ (Figs. 2 and 3), the node $N_3$ being common to each source of the transistors $Q_3$ and $Q_4$. Thus the flip-flop FF is energized, and if the relationship $V_{N1} < V_{N2}$ stands ($a = $"H"), the transistor $Q_3$ is turned ON and at the same time the transistor $Q_4$ is turned OFF. Thereby, the voltage $V_{N1}$ is reduced to the voltage level $V_{SS}$ and, at the same time, the voltage $V_{N2}$ is increased to the voltage level $V_{CC}$, which means that the flip-flop FF has functioned as a voltage amplifier. Contrary to the above, if the relationship $V_{N1} > V_{N2}$ stands ($a = $"L"), the transistor $Q_3$ is turned OFF and, at the same time, the transistor $Q_4$ is turned ON. Thereby, the voltage $V_{N1}$ is reduced to the voltage level $V_{SS}$ and, at the same time, the voltage $V_{N2}$ is increased to the voltage level $V_{CC}$.

During the term preceding the application of the clock $\phi_0$, a certain state is provided in which the voltage levels at both nodes $N_6$ and $N_7$ (corresponding to the drains of the transistors $Q_{10}$ and $Q_{11}$, respectively) are precharged to a level of $(V_{CC} - V_{th})$. This occurs because, in this state, the voltage $V_{CC}$ is directly applied to the nodes $N_1$ and $N_2$ which causes the transistors $Q_{10}$ and $Q_{11}$ to be conductive, thereby causing the nodes $N_6$ and $N_7$ to be charged up with certain reduction of the voltage (threshold voltage $V_{th}$ of each of the transistors $Q_{10}$ and $Q_{11}$). However, when the above-mentioned state is changed to the next stage, in which the clock $\phi_1$ is activated, since the flip-flop FF is energized one or other of the

transistors $Q_{10}$ and $Q_{11}$ is turned OFF in accordance with the logic of the input $a$. For example, if the logic of the input $a$ is "L", the transistor $Q_{10}$ is turned OFF and, at the same time, the transistor $Q_{11}$ is turned ON, because, in this state, the voltage levels at the nodes $N_1$ and $N_2$ are set to be $V_{N1}$, equal to $V_{CC}$, and $V_{N2}$, nearly equal to $V_{SS}$, respectively; that is, $V_{N1}=V_{CC}$ and $V_{N2}\simeq V_{SS}$. Then, the electric charges stored at the node $N_7$ are absorbed toward the node $N_2$, now having the level $V_{SS}$, via the conductive transistor $Q_{11}$. On the other hand, in this state, since the transistor $Q_{10}$ is nonconductive, the electric charges stored at the node $N_6$ remain as they are. Due to the presence of the electric charges at the node $N_6$, the MOS transistor $Q_{12}$ is made fully conductive when the clock AD, having the level of $V_{CC}$, is generated, because the so-called bootstrap effect is affected to the transistor $Q_{12}$ by the above-mentioned electric charges. Then the address $\overline{A}$, having logic "H", is produced. The waveform of the clock AD is not shown in Fig. 3, but in Figs. 6A and 6B. In this state, since the transistor $Q_{15}$ is turned ON, while the transistors $Q_{13}$ and $Q_{14}$ are turned OFF, the address A is changed to logic "L" being equal to the level of $V_{SS}$. The above-mentioned operation is performed under the condition where the input $a$ has logic "L". Thereby, the address A becomes logic "L", identical to the logic of the input $a$, while the inverting address $\overline{A}$ becomes logic "H".

Contrary to the above, if the operation of the circuit shown in Fig. 2 is achieved under the condition where the input $a$ has logic "H", the voltage level $V_{N1}$ is almost the same as the level of $V_{SS}$ and $V_{N2}$ is the same as the level $V_{CC}$. Therefore, the transistor $Q_{10}$ is turned ON, but the transistor $Q_{11}$ is turned OFF. Under such conditions, when the clock AD is generated, the transistors $Q_{13}$ and $Q_{14}$ are turned ON, while the transistors $Q_{12}$ and $Q_{15}$ are turned OFF. As a result, the address A having logic "H" and the inverted address $\overline{A}$ having logic "L" are produced simultaneously.

During the refresh operation mode, the following operations are executed in the memory sequentially until the production of both the addresses A and $\overline{A}$ are completed: (1) Changing of the external clock $\overline{RFSH} \rightarrow$ (2) generating the clocks PRF and $\overline{PRF}$ from the refresh clock generator $1 \rightarrow$ (3) exchanging the external address ADD with the refresh address R under control of the clocks PRF and $\overline{PRF} \rightarrow$ (4) generating the clock $RF \rightarrow$ (5) generating the clock $\phi_0$ from the address drive clock generator $2 \rightarrow$ ... and so on. In executing the above-mentioned operations, certain defects arise in that it takes a relatively long time from when the above operation (2) is executed to the time when the above operation (5) is executed. In other words, the generation of the clock $\phi_0$ should not be started until the logic level of the input $a$ from the multiplexer 8 is fully saturated to a predetermined level (refer to a time $t_0$ in Fig. 3). Thus, a waiting time should be created in the address buffer 7. With reference to Fig. 3, the waiting time is indicated by the reference symbol $t_w$. This is the reason why the addres buffer 7 of Fig. 2 may not operate sufficiently rapidly. To be more spefific, the above-mentioned defect is derived from the existences of both the multiplexer 8 and the input circuit IN, shown in Fig. 2, as will be explained hereinafter.

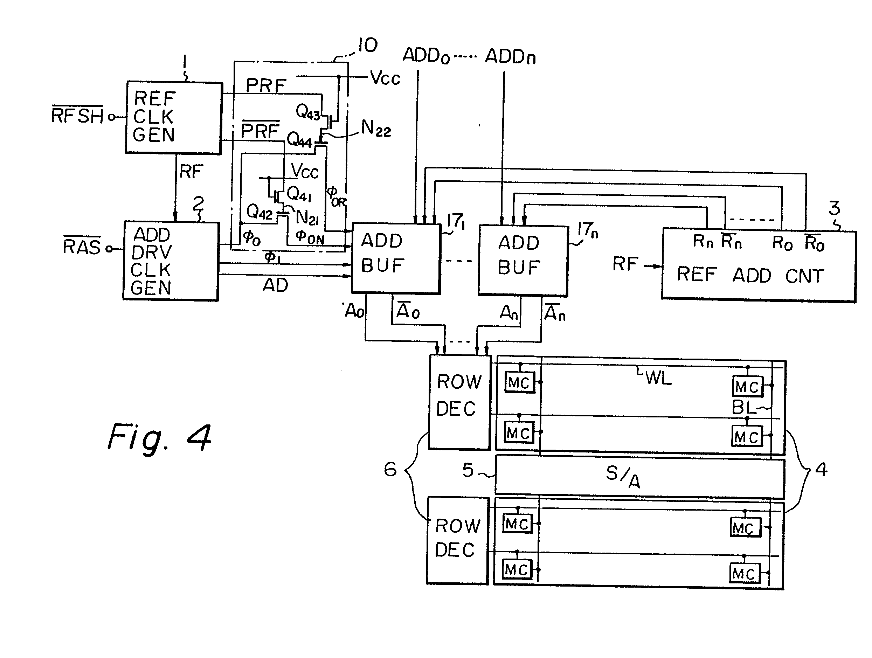

An embodiment of the present invention, which can improve the operating speed of the memory, specifically by shortening the length of the above-mentioned waiting time $t_w$, will now be discussed with reference to Fig. 4.

In Fig. 4 elements which are identical to those of Fig. 1 are represented by the same reference numerals and symbols. Therefore, elements 10 and $17_1$ to $17_n$ are newly employed in the memory of Fig. 4. However, elements corresponding to the address buffer (ADD BUF) $17_1$ to $17_n$ are illustrated in Fig. 1 as the address buffer $7_1$ to $7_n$. The element 10 is a switch. During normal operation mode, the switch 10 switches the clock $\phi_0$ produced by the address drive clock generator 2 to a first signal path for transferring a clock $\phi_{ON}$; alternatively, the switch 10 switches the clock $\phi_0$ to a second path for transferring a clock $\phi_{OR}$. In this case, during normal operation mode, the refresh clock generator 1 produces the clock $\overline{PRF}$ having logic "H", and, accordingly, the logic at node $N_{21}$ is changed to "H", via a MOS transistor $Q_{41}$, which voltage level is equal to $(V_{CC}-V_{th})$, where $V_{th}$ is a threshold voltage of the transistor $Q_{41}$. Then, the clock $\phi_0$ is transferred, as the clock $\phi_{ON}$, from the address drive clock generator 2 to the inputs of the address buffers $17_1$ to $17_n$ via a MOS transistor $Q_{42}$. In this case, it is preferable to maintain the voltage level of the clock $\phi_{ON}$ equal to or higher than that of the source clock $\phi_0$, so as to drive the address buffers $17_1$ to $17_n$ strongly. In order to accomplish this, the MOS transistor $Q_{41}$ is employed. Theoretically, in the switch 10, the clock $\phi_0$ can be switched to the clock $\phi_{ON}$ or $\phi_{OR}$ only by using the gate transistors $Q_{42}$ and $Q_{44}$ controlled directly by the clocks $\overline{PRF}$ and PRF, where the voltage levels of the clocks $\phi_{ON}$ and $\phi_{OR}$ are lower than that of the clock $\phi_0$. However, if the combination of the transistors $Q_{41}$ and $Q_{42}$ and also the combination of the transistors $Q_{43}$ and $Q_{44}$ are introduced into the switch 10, the so-called bootstrap effect is created in each of these combinations. In this case, the voltage levels at the nodes $N_{21}$ and $N_{22}$ are maintained at a level higher than the level $V_{CC}$.

Contrary to the above, during the refresh operation mode, the refresh clock generator 1 produces the clock PRF having logic "H", and, accordingly, the MOS transistor $Q_{44}$ is turned ON, so that the clock $\phi_0$ is transferred, as the clock $\phi_{OR}$, to the inputs of the address buffers $17_1$ to $17_n$. Thus, the clock $\phi_{OR}$ and the above-mentioned clock $\phi_{ON}$ are supplied alternatively from the switch 10. In accordance with the clock $\phi_{ON}$ or $\phi_{OR}$, the external addresses $ADD_0$ to $ADD_n$, the refresh addresses $R_0$ to $R_n$ or the inverting

addresses $\overline{R}_0$ to $\overline{R}_n$ are selectively applied to the address buffers $17_1$ to $17_n$.

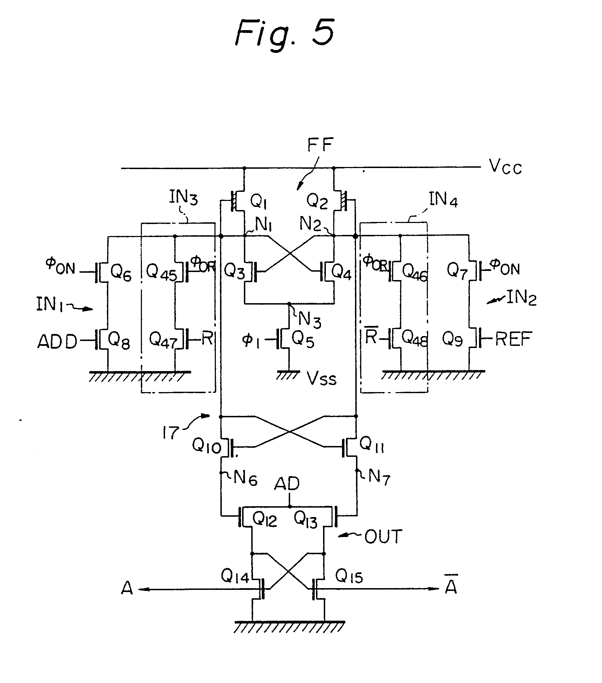

Fig. 5 is a detailed circuit diagram representing one of the address buffers (ADD BUF) $17_1$ to $17_n$ shown in Fig. 4. This circuit diagram corresponds to that of Fig. 2. Accordingly, elements which are identical to those of Fig. 2 are represented by the same reference numerals and symbols. Since in Fig. 4 the address buffers $17_1$ to $17_n$ have the same construction as one another, only one of them is illustrated with the reference numeral 17. As compared with the circuit diagram of Fig. 2, in Fig. 5, the external address input circuit (first input circuit) $IN_1$ and also the reference voltage input circuit (second input circuit) $IN_2$ are still useful in the address buffer 17. However, the following three points should be noted. Firstly, the multiplexer 8, which is employed in the address buffer of Fig. 2, is not used in the address buffer 17 and no such multiplexer is shown in Fig. 5. The reason for this is that, due to the presence of the multiplexer 8, the voltage level of the input a (Fig. 2) rises very slowly to its saturation level within the aforementioned waiting time $t_w$ (Fig. 3). This is because the mutual conductances $g_m$ of the MOS transistors $Q_{31}$ and $Q_{32}$ comprising the multiplexer 8 prevent the input a level from rising quickly. Secondly, the input circuits $IN_1$ and $IN_2$ of Fig. 5 do not directly receive the clock $\phi_0$, as in Fig. 2, but receive the clock $\phi_{ON}$ via the switch 10 (Fig. 4). Thirdly, a third input circuit $IN_3$ and a fourth input circuit $IN_4$ are newly employed. The third input circuit $IN_3$ is connected, as a whole, in parallel with the first input circuit $IN_1$. In addition, the circuit $IN_3$ receives the clock $\phi_{OR}$ and the refresh address R. The fourth input circuit $IN_4$ is connected, as a whole, in parallel with the second input circuit $IN_2$. In addition, the circuit $IN_4$ receives the clock $\phi_{OR}$ and the inverted refresh address $\overline{R}$. In this case, the first and second input circuits $IN_1$ and $IN_2$ are activated by the application of the clock $\phi_{ON}$, while the third and fourth input circuits $IN_3$ and $IN_4$ are activated by the application of the clock $\phi_{OR}$. That is, the MOS transistors $Q_6$ and $Q_7$ of the input circuits $IN_1$ and $IN_2$ respectively are turned ON by the clock $\phi_{ON}$ during only the normal operation mode. The third input circuit $IN_3$ comprises MOS transistors $Q_{45}$ and $Q_{47}$ connected in series, which MOS transistor $Q_{45}$ is turned ON by the clock $\phi_{OR}$ only during the refresh operation mode. Similarly, the fourth input circuit $IN_4$ comprises MOS transistors $Q_{46}$ and $Q_{48}$ connected in series, which MOS transistor $Q_{46}$ is turned ON by the clock $\phi_{OR}$ only during the refresh operation mode.

Fig. 6A is a timing diagram used for explaining the operation of the address buffer shown in Fig. 5, during the refresh operation mode. Fig. 6B is a timing diagram used for explaining the operation of the address buffer shown in Fig. 5, during the normal operation mode. In Fig. 6A, during the refresh operation mode, first the logic of the clock $\overline{RFSH}$ is changed from "H" to "L" and then the logic of the clock PRF is changed from "L" to "H" and, at the same time, the logic of the clock $\overline{PRF}$ is changed from "H" to "L" (these clocks PRF and $\overline{PRF}$ are produced by the refresh clock generator 1), which operations are identical to those represented in Fig. 3. However, in Fig. 6A, the clock $\phi_0$ and, accordingly, the clock $\phi_{OR}$ can be generated soon after the logic changes of the clocks PRF and $\overline{PRF}$. In other words, it is not necessary to wait until the time the voltage level of the slow rising input a reaches its saturation level so as to generate the clock $\phi_0$, as occurs in Fig. 3. As a result, the waiting time $t_w$ of Fig. 3 is considerably shortened to a waiting time $t_w'$ shown in Fig. 6A and thereby a high speed operation of the address buffer can be expected. The reason why the input a can be removed from the address buffer 17 is that no element similar to the multiplexer 8 of Fig. 2 is used, but, instead of such a multiplexer 8, the third and fourth input circuits $IN_3$ and $IN_4$ are employed in Fig. 5. Thus, a dynamic memory embodying the present invention can operate with a high operating speed, as compared to that of Fig. 1.

In Fig. 6A, the characteristic curves $N_{21}$, $N_{22}$, PRF, $\overline{PRF}$, RF and $\overline{RFSH}$ indicate the respective levels appearing in Fig. 4, but not in Fig. 5. Regarding characteristic curves $\phi_0$, RF and PRF, $\overline{PRF}$, since the clock $\phi_0$ is produced with a certain time delay after the generation of the clock RF, the clocks RF, PRF, $\overline{PRF}$ may be activated at approximately the same time as each other. Regarding the characteristic curve $N_{22}$, the voltage level at the node $N_{22}$ can be increased above the level $V_{CC}$, due to the previously mentioned bootstrap effect.

In Fig. 6B, during the normal operation mode, the logic of the clock $\phi_{ON}$ is changed to "L" and, accordingly, the first and second input circuits are left in an idle state. Thus, a current flows through the third input circuit $IN_3$ or the second input circuit $IN_2$ (also the fourth input circuit $IN_4$), alternatively. Since the transistor $Q_9$ is always made conductive by the reference voltage REF, the above-mentioned current can flow through the circuit $IN_2$ and also circuit $IN_4$. If $IN_2$ is activated by $\phi_0$ instead of $\phi_{ON}$, the fourth input circuit $IN_4$ can theoretically be omitted from the address buffer 17. However, it is actually preferable to employ not only the third input circuit $IN_3$, but also the fourth input circuit $IN_4$. This is because it is preferable to mount the same load ($IN_3$, $IN_4$) seen from each of the nodes $N_1$ and $N_2$ in view of a circuit balance.

Returning again to Figs. 5 and 6A, the flip-flop FF is liable to be latched in either one of the two states, according to the logic of the refresh addresses R and $\overline{R}$. For example, when the address R is set to be logic "H" and, accordingly, the address $\overline{R}$ is "L", the following relationship stands between the voltage levels $V_{N1}$ at the node $N_1$ and $V_{N2}$ at the node $N_2$, that is $V_{N1} < V_{N2}$. Accordingly, the clock $\phi_1$ is applied from the clock generator 2 to ths transistor $Q_5$, at its gate, and the flip-flop FF is activated so as to make the transistors $Q_3$ and $Q_4$ ON and OFF, respectively. Then, the voltage level $V_{N1}$ is changed to the level

$V_{SS}$, while, the voltage level $V_{N2}$ is changed to the level $V_{CC}$. As a result, the output circuit OUT produces the address A of logic "H" and the address $\overline{A}$ of logic $\overline{L}$, simultaneously, so as to access the memory arrays 4.

In Fig. 6B, during the normal operation mode, the clocks $\overline{PRF}$ of logic "H" and PRF of logic "L" are produced by the clock generator 1 (Fig. 5), and, thereby, the clocks $\phi_{ON}$ of logic "H" and $\phi_{OR}$ of logic "L" are generated in the switch 10 (Fig. 5). Thus, only the first and the second input circuits $IN_1$ and $IN_2$ are activated.

Thus it can be ensured that relatively little time for switching the external address ADD to the refresh address R and vice versa is required, and, accordingly, a considerably high speed operating address buffer can be realized.

**Claims**

1. A dynamic memory device including address buffer circuitry (17) provided with input means ($IN_1$—$IN_3$) connected to apply either an external address signal (ADD) or an internal refresh address signal (R) to a first input/output node ($N_1$) of a flip-flop (FF) of the address buffer circuitry (17) so that the flip-flop (FF) is latched into either one of its two stable states upon receipt of the external address signal (ADD) or upon receipt of the internal refresh address signal (R); the said input means including first input circuitry ($IN_1$), connected to the said first input/output node ($N_1$) of the flip-flop (FF) and comprising first and second transistors ($Q_6$, $Q_8$) connected together in series, and also including second input circuitry ($IN_2$), connected to a second input/output node ($N_2$) of the flip-flop (FF) and comprising third and fourth transistors ($Q_7$, $Q_9$) connected together in series, the gate of the said third transistor ($Q_7$) being connected to receive a basic timing clock signal ($\phi_0$) from an address drive clock generator (2) of the device and the gate of the said fourth transistor ($Q_9$) being connected to receive a reference voltage (REF); there being output circuitry (OUT) coupled to the said flip-flop (FF) for producing output address signals (A, $\overline{A}$);

characterised in that the device further includes switching means (10) operable to switch the said basic timing clock signal ($\phi_0$) so as to produce either an internal refresh address timing clock signal ($\phi_{OR}$), during a period in which a refresh operation of the device is to be performed, or an external address timing clock signal ($\phi_{ON}$), during a period of normal operation of the device, which clock signals ($\phi_{OR}$, $\phi_{ON}$) are delivered to the said input means;

and in that the said input means further include third input circuitry ($IN_3$) connected in parallel with the said first input circuitry ($IN_1$) and comprising fifth and sixth transistors ($Q_{45}$, $Q_{47}$) connected together in series, respective gates of the said fifth and sixth transistors ($Q_{45}$, $Q_{47}$) being connected to receive respectively the said internal refresh address timing clock signal ($\phi_{OR}$) and the said internal refresh address signal (R);

and in that respective gates of the said first and second transistors ($Q_6$, $Q_8$) of the first input circuitry ($IN_1$) are connected to receive respectively the said external address timing clock signal ($\phi_{ON}$) and the said external address signal (ADD).

2. A dynamic memory device including address buffer circuitry (17) provided with input means ($IN_1$—$IN_4$) connected to apply either an external address signal (ADD) or an internal refresh address signal (R) to a first input/output node ($N_1$) of a flip-flop (FF) of the address buffer circuitry (17) so that thip-flop (FF) is latched into either one of its two stable states upon receipt of the external address signal (ADD) or upon receipt of the internal refresh address signal (R); the said input means including first input circuitry ($IN_1$), connected to the said first input/output node ($N_1$) of the flip-flop (FF) and comprising first and second transistors ($Q_6$, $Q_8$) connected together in series, and also including second input circuitry ($IN_2$), connected to a second input/output node ($N_2$) of the flip-flop (FF) and comprising third and fourth transistors ($Q_7$, $Q_9$) connected together in series, the gate of the said fourth transistor ($Q_9$) being connected to receive a reference voltage (REF); there being output circuitry (OUT) coupled to the said flip-flop (FF) for producing output address signals (A, $\overline{A}$);

characterised in that the devices further includes switching means (10) operable to switch a basic timing clock signal ($\phi_0$) from an address drive clock generator (2) of the device so as to produce either an internal refresh address timing clock signal ($\phi_{OR}$), during a period in which a refresh operation of the device is to be performed, or an external address timing clock signal ($\phi_{ON}$), during a period of normal operation of the device, which clock signals ($\phi_{OR}$, $\phi_{ON}$) are delivered to the said input means;

and in that the said input means further include third input circuitry ($IN_3$) connected in parallel with the said first input circuitry ($IN_1$) and comprising fifth and sixth transistors ($Q_{45}$, $Q_{47}$) connected together in series, respective gates of the said fifth and sixth transistors ($Q_{45}$, $Q_{47}$) being connected to receive respectively the said internal refresh address timing clock signal ($\phi_{OR}$) and the said internal refresh address signal (R), and also include fourth input circuitry ($IN_4$) connected in parallel with the said second input circuitry ($IN_2$) for receiving an inverted internal refresh address signal ($\overline{R}$) and the said internal refresh address timing clock signal ($\phi_{OR}$);

and in that respective gates of the said first and third transistors ($Q_6$, $Q_7$) of the first and second input circuitry ($IN_1$, $IN_2$) are connected to receive the said external address timing clock signal ($\phi_{ON}$) and a gate of the said second transistor ($Q_8$) of the first input circuitry ($IN_1$) is connected to receive the said external address signal (ADD).

3. A device as claimed in claim 2, wherein the said fourth input circuitry ($IN_4$) comprises a seventh transistor ($Q_{46}$) and an eighth transistor ($Q_{48}$), connected together in series, which seventh and eighth transistors receive, at respective gates thereof, the said internal refresh address timing clock signal ($\phi_{OR}$) and the said inverted internal refresh address signal ($\bar{R}$).

4. A device as claimed in claim 1, 2 or 3, wherein the said switching means (10) comprise a first gate transistor ($Q_{42}$) and a second gate transistor ($Q_{44}$) operable alternatively to deliver to the said input means the said external address timing clock signal ($\phi_{ON}$) and the said internal refresh address timing clock signal ($\phi_{OR}$) respectively.

5. A device as claimed in claim 4, wherein the said switching means (10) further comprise first and second auxiliary transistors ($Q_{41}$, $Q_{43}$) connected and arranged so as to perform respective bootstrap operations at the gates of the said first and second gate transistors ($Q_{24}$, $Q_{44}$) respectively.

**Patentansprüche**

1. Dynamische Speichervorrichtung mit einer Adreßpufferschaltung (17), die mit Eingangseinrichtungen (IN$_1$—IN$_3$) versehen ist, die angeschlossen sind, um entweder ein externes Adreßsignal (ADD) oder ein internes Auffrischadreßsignal (R) einem ersten Eingangs/Ausgangs-Knoten (N$_1$) eines Flip-Flop (FF) der Adreßpufferschaltung (17) zuzuführen, so daß das Flip-Flop (FF), bei Empfang des äußeren Adreßsignals (ADD) oder bei Empfang des internen Auffrischadreßsignals (R), in einem seiner beiden stabilen Zustände arretiert wird; bei der die genannte Eingangseinrichtung eine erste Eingangsschaltung (IN$_1$) umfaßt, die mit dem genannten ersten Eingangs/Ausgangs-Knoten (N$_1$) des Flip-Flop (FF) verbunden ist, und erste und zweite Transistoren ($Q_6$, $Q_8$) umfaßt, die miteinander in Reihe verbunden sind, und auch eine zweite Eingangsschaltung (IN$_2$) umfaßt, die mit einem zweiten Eingangs/Ausgangs-Knoten (N$_2$) des Flip-Flop (FF) verbunden ist und dritte und vierte Transistoren ($Q_7$, $Q_9$) umfaßt, die miteinander in Reihe verbunden sind, wobei das Gate des genannten dritten Transistors ($Q_7$) verbunden ist, um ein Grundzeit-Taktsignal ($\phi_0$) von einem Adreßtreibertaktgenerator (2) der Vorrichtung zu empfangen, und das Gate des genannten vierten Transistors ($Q_9$) angeschlossen ist, um eine Referenzspannung (REF) zu empfangen; bei der eine Ausgangsschaltung (OUT) mit dem genannten Flip-Flop verbunden ist, um Ausgangsadreßsignale (A, $\bar{A}$) zu erzeugen; dadurch gekennzeichnet, daß die Vorrichtung ferner eine Schalteinrichtung (10) umfaßt, die betreibbar ist, um das genannten Grundzeit-Taktsignal ($\phi_0$) so zu schalten, daß entweder ein internes Auffrischadreßzeittaktsignal ($\phi_{OR}$) erzeugt wird, während einer Periode, in der eine Auffrischbetrieb der Vorrichtung durchgeführt werden soll, oder ein externes Adreßzeittaktsignal ($\phi_{ON}$), während einer Periode des normalen Betriebs der Vorrichtung, welche Taktsignale ($\phi_{OR}$, $\phi_{ON}$) an die genannte Eingangseinrichtung geliefert werden;

und daß die genannten Eingangseinrichtung ferner eine dritte Eingangsschaltung (IN$_3$) umfaßt, die parallel zu der genannten ersten Eingangsschaltung (IN$_1$) verbunden ist und fünfte und sechste Transistoren ($Q_{45}$, $Q_{47}$) umfaßt, die miteinander in Reihe verbunden sind, wobei die Gates des fünften bzw. sechsten Transistors ($Q_{45}$, $Q_{47}$ angeschlossen sind, um das interne Auffrischadreßzeittaktsignal ($\phi_{OR}$) bzw. das genannte interne Auffrischadreßsignal (R) zu empfangen;

und daß die jeweiligen Gates der ersten und zweiten Transistoren ($Q_6$, $Q_8$) der ersten Eingangsschaltung (IN$_1$) angeschlossen sind, um das genannte externe Adreßzeittaktsignal ($\phi_{ON}$) bzw. das genannte externe Adreßsignal (ADD) zu empfangen.

2. Dynamische Speichervorrichtung mit einer Adreßpufferschaltung (17), die mit Eingangseinrichtungen (IN$_1$—IN$_4$) versehen ist, die verbunden sind, um entweder ein externes Adreßsignal (ADD) oder ein internes Auffrischadreßsignal (R) an einen ersten Eingangs/Ausgangs-Knoten (N$_1$) eines Flip-Flop (FF) der Adreßpufferschaltung (17) zu liefern, so daß das Flip-Flop (FF) bei Empfang des externen Adreßsignals (ADD) oder bei Empfang des internen Auffrischadreßsignals (R) in einen seiner beiden Zustände arretiert wird; bei der die genannte Eingangseinrichtung eine erste Eingangsschaltung (IN$_1$) umfaßt, die mit dem genannte ersten Eingangs/Ausgangs-Knoten (N$_1$) des Flip-Flop (FF) verbunden ist und erste und zweite Transistoren (Q6, Q8) umfaßt, die miteinander in Reihe verbunden sind, und ferner eine zweite Eingangsschaltung (IN$_2$) umfaßt, die mit einem zweiten Eingangs/Ausgangs-Knoten (N$_2$) des Flip-Flop (FF) verbunden ist und dritte und vierte Transistoren (Q7, Q9) umfaßt, die in Reihe miteinander verbunden sind, wobei das Gate des genannten vierten Transistors (Q9) angeschlossen ist, um eine Referenzspannung zu empfangen; bei der ferner eine Ausgangsschaltung (OUT) vorgesehen ist, die mit dem genannten Flip-Flop (FF) gekoppelt ist, um Ausgangsadreßsignale (A, $\bar{A}$) zu erzeugen;

dadurch gekennzeichnet, daß die Vorrichtung ferner eine Schalteinrichtung (10) umfaßt, die betreibbar ist, um ein Grundzeit-Taktsignal ($\phi_0$) von einem Adreßtreibertaktgenerator (2) der Vorrichtung zu schalten, um so entweder ein internes Auffrischadreßzeittaktsignal ($\phi_{OR}$) zu erzeugen, während einer Periode, während welcher ein Auffrischbetrieb der Vorrichtung durchgeführt werden soll, oder ein externes Adreßzeittaktsignal ($\phi_{ON}$), während einer Periode eines normalen Betriebs der Vorrichtung, welche Taktsignale ($\phi_{OR}$, $\phi_{ON}$) an die genannten Eingangseinrichtung geliefert werden;

und daß die genannte Eingangseinrichtung ferner eine dritte Eingangsschaltung (IN$_3$) umfaßt, die parallel zu der genannten ersten Eingangsschaltung (IN$_1$) angeordnet ist und fünfte und sechste Transistoren ($Q_{45}$, $Q_{47}$) umfaßt, die in Reihe miteinander verbunden sind, wobei die jeweiligen Gates der fünften und sechsten

Transistoren ($Q_{45}$, $Q_{47}$) mit dem genannten internen Auffrischadreßzeittaktsignal ($\phi_{OR}$) bzw. dem genannten internen Auffrischsignal (R) verbunden sind, und ferner eine vierte Eingangsschaltung ($IN_4$) umfaßt, die parallel zu der genannten Eingangsschaltung ($IN_2$) verbunden ist, um ein invertiertes internes Auffrischadreßsignal ($\bar{R}$) und das genannte interne Auffrischadreßzeittaktsignal ($\phi_{OR}$) zu empfangen;

und daß die jeweiligen Gates der genannten ersten und dritten Transistoren ($Q_6$, $Q_7$) der ersten und zweiten Eingangsschaltung ($IN_1$, $IN_2$) angeschlossen sind, um das genannte externe Adreßzeittaktsignal ($\phi_{ON}$) zu empfangen, und ein Gate des genannten zweiten Transistors ($Q_8$) der ersten Eingangsschaltung ($IN_1$) angeschlossen ist, um das genannte externe Adreßsignal (ADD) zu empfangen.

3. Vorrichtung nach Anspruch 2, bei der die genannte vierte Eingangsschaltung ($IN_4$ einen siebten Transistor ($Q_{46}$) und einen achten Transistor ($Q_{48}$) umfaßt, die in Reihe miteinander verbunden sind, welche siebte und achte Transistoren jeweils an ihren Gates das genannte interne Auffrischadreßzeittaktsignal ($\phi_{OR}$) bzw. das genannte invertierte interne Auffrischadreßsignal ($\bar{R}$) empfangen.

4. Vorrichtung nach Anspruch 1, 2 oder 3, bei der die genannte Schalteinrichtung (10) einen ersten Gatetransistor ($Q_{42}$) und einen zweiten Gatetransistor ($Q_{44}$) umfaßt, die alternativ betreibbar sind, um an die Eingangseinrichtung das genannte externe Adreßzeittaitsignal ($\phi_{ON}$) bzw. das genannte interne Adreßzeittaktsignal ($\phi_{OR}$) zu liefern.

5. Vorrichtung nach Anspruch 4, bei der die genannte Schalteinrichtung (10) ferner erste und zweite Hilfstransistoren ($Q_{41}$, $Q_{43}$) umfaßt, die so angeschlossen und angeordnet sind, daß sie jeweils Bootstrap-Operationen an den Gates der ersten bzw. zweiten Gatetransistoren ($Q_{42}$, $Q_{44}$) durchführen.

**Revendications**

1. Dispositif de mémoire dynamique comportant un circuit tampon d'adresse composé (17) pourvu de moyens d'entrée (IN1—IN3) connectées pour appliquer soit un signal d'adresse externe (ADD) soit un signal d'adresse de rafraîchissement interne (R) à un premier noeud d'entrée/sortie ($N_1$) d'une bascule (FF) du circuit tampon d'adresse composé (17), de manière que la bascule (FF) soit verrouillée dans l'un ou l'autre de ses deux états stables à la suite de la réception du signal d'adresse externe (ADD) ou à la suite de la réception du signal d'adresse de rafraîchissement interne (R); lesdits moyens d'entrée incluant un premier circuit composé d'entrée ($IN_1$) connecté audit premier noeud d'entrée/sortie ($N_1$) de la bascule (FF) et comprenant un premier et un deuxième transistor (Q6, Q8) connectés mutuellement en série, et incluant aussi un deuxième circuit composé d'entrée ($IN_2$) connecté à un deuxième noeud d'entrée/sortie ($N_2$) de la bascule (FF) et comprenant un troisième et un quatrième transistor (Q7, Q9) connectés mutuellement en série, la grille dudit troisième transistor (Q7) étant connectée pour recevoir un signal d'horloge de cadencement de base ($\phi_0$) provenant d'un générateur de signaux d'horloge de commande d'adresse (2) du dispositif, et la grille dudit quatrième transistor (Q9) étant connectée pour recevoir une tension de référence (REF); un circuit de sortie composé (OUT) étant couplé à ladite bascule (FF) pour produire des signaux de sortie d'adresse (A, $\bar{A}$);

caractérisé en ce que le dispositif comporte en outre des moyens de commutation (10) aptes à commuter ledit signal d'horloge de cadencement de base ($\phi_0$) de manière à produire soit un signal d'horloge de cadencement d'adresse de rafraîchissement interne ($\phi_{OR}$) au cours d'une période dans laquelle une opération de rafraîchissement du dispositif doit être accompli, soit un signal d'horloge de cadencement d'adresse externe ($\phi_{ON}$), au cours d'une période de fonctionnement normal du dispositif, lesdits signaux d'horloge ($\phi_{OR}$, $\phi_{ON}$) étant fournis auxdits moyens d'entrée;

et en ce que lesdits moyens d'entrée comportent en outre un troisième circuit d'entrée composé ($IN_3$) connecté en parallèle avec ledit premier circuit d'entrée composé ($IN_1$) et comprenant un cinquième et un sixième transistor (Q45, Q47) mutuellement connectés en série, les grilles respectives desdits cinquième et sixième transistor (Q45, Q47) étant connectées pour recevoir respectivement ledit signal d'horloge de cadencement d'adresse de rafraîchissement interne ($\phi_{OR}$) et ledit signal d'adresse de rafraîchissement interne (R);

et en ce que les grilles respectives desdits premier et deuxième transistor (Q6, Q8) du premier circuit d'entrée composé ($IN_1$) sont connectées pour recevoir respectivement ledit signal d'horloge de cadencement d'adresse externe ($\phi_{ON}$) et ledit signal d'adresse externe (ADD).

2. Dispositif de mémoire dynamique incluant un circuit tampon d'adresse composé (17) pourvu de moyens d'entrée (IN1—IN4) connectés pour appliquer soit un signal d'adresse externe (ADD), soit un signal d'adresse de rafraîchissement interne (R) à un premier noeud d'entrée/sortie ($N_1$) d'une bascule (FF) du circuit tampon d'adresse composé (17) de manière que la bascule (FF) soit verrouillée dans l'un ou l'autre de ses deux états stables à la suite de la réception du signal d'adresse externe (ADD) ou à la suite de la réception du signal d'adresse de rafraîchissement interne (R); lesdits moyens d'entrée incluant un premier circuit d'entrée composé ($IN_1$) connecté audit premier noeud d'entrée/sortie ($N_1$) de a bascule (FF) et comprenant un premier et un deuxième transistor (Q6, Q8) mutuellement connectés en série, et incluant aussi un deuxième circuit d'entrée composé ($IN_2$) connecté à un deuxième noeud d'entrée/sortie ($N_2$) de la bascule

(FF) et comprenant un troisième et un quatrième transistor (Q7, Q9) mutuellement connectés en série, la grille dudit quatrième transistor (Q9) étant connectée pour recevoir une tension de référence (REF); un circuit de sortie composé (OUT) étant couplé à ladite bascule (FF) pour produite des signaux de sortie d'adresse (A, $\bar{A}$);

caractérisé en ce que le dispositif comporte en outre des moyens de commutation (10) aptes à commuter un signal d'horloge de cadencement de base ($\phi_0$) provenant d'un générateur de signaux d'horloge de commande d'adresse (2) du dispositif de manière à produire soit un signal d'horloge de cadencement d'adresse de rafraîchissement interne ($\phi_{OR}$), au cours d'une période dans laquelle une opération de rafraîchissement du dispositif doit être accomplie, soit un signal d'horloge de cadencement d'adresse externe ($\phi_{ON}$), au cours d'une période de fonctionnement normal du dispositif, lesdits signaux d'horloge ($\phi_{OR}$, $\phi_{ON}$) étant fournis auxdits moyens d'entrée;

et en ce que lesdits moyens d'entrée comportent en outre un troisième circuit d'entrée composé (IN$_3$) connecté en parallèle avec ledit premier circuit d'entrée composé (IN$_1$) et comprenant un cinquième et un sixième transistor (Q45, Q47) mutuellement connectés en série, les grilles respectives desdits cinquième et sixième transistor (Q45, Q47) étant connectées pour recevoir respectivement ledit signal d'horloge de cadencement d'adresse de rafraîchissement interne ($\phi_{OR}$) et ledit signal d'adresse de rafraîchissement interne (R), et comportent en outre un quatrième circuit d'entrée composé (IN$_4$) connecté en parallèle avec ledit deuxième circuit d'entrée composé (IN$_2$) pour recevoir un signal d'adresse de rafraîchissement interne inversé ($\bar{R}$) et ledit signal d'horloge de cadencement d'adresse de rafraîchissement interne ($\phi_{OR}$);

et en ce que les grilles respectives desdits premier. et troisième transistor (Q6, Q7) du premier et du deuxième circuit d'entrée composé (IN$_1$, IN$_2$) sont connectées pour recevoir ledit signal d'horloge de cadencement d'adresse externe ($\phi_{ON}$), et une grille dudit deuxième transistor (Q8) du premier circuit d'entrée composé (IN$_1$) est connectée pour recevoir ledit signal d'adresse externe (ADD).

3. Dispositif selon revendication 2, dans lequel ledit quatrième circuit d'entrée composé (IN$_4$) comprend un septième transistor (Q46) et un huitième transistor (Q48) mutuellement connectées en série, ce septième et ce huitième transistor recevant, à leurs grilles respectives, ledit signal d'horloge de cadencement de rafraîchissement interne ($\phi_{OR}$) et ledit signal d'adresse de rafraîchissement interne inversé ($\bar{R}$).

4. Dispositif selon revendication 1, 2 ou 3 dans lequel lesdits moyens de commutation (10) comprennent un premier transistor-porte (Q42) et un deuxième transistor-porte (Q44) aptes à opérer alternativement pour fournir respectivement auxdits moyens d'entrée ledit signal d'horloge de cadencement d'adresse externe ($\phi_{ON}$) et ledit signal d'horloge de cadencement d'adresse de rafraîchissement interne ($\phi_{OR}$).

5. Dispositif selon revendication 4, dans lequel lesdits moyens de commutation (10) comprennent en outre un premier et un deuxième transistor auxiliaire (Q41, Q43) connectés et agencés de manière à accomplir des opérations d'amorçage respectives, respectivement aux grilles dudit premier et dudit deuxième transistor-porte (Q42, Q44).

*Fig. 1*

*Fig. 2*

*Fig. 3*

Fig. 4

# Fig. 5

# Fig. 6A

# Fig. 6 B